# EUROPÄISCHE PATENTANMELDUNG

(11) **EP 1 521 308 A1**
(43) Veröffentlichungstag der Anmeldung: **06.04.2005**
(21) Anmeldenummer: 03022301.0
(22) Anmeldetag: 02.10.2003
(51) Int. Cl.: H01L 31/032, H01L 31/0352, H01L 31/0336

(54) **Kugel- oder kornförmiges Halbleiterbauelement zur Verwendung in Solarzellen und Verfahren zur Herstellung; Verfahren zur Herstellung einer Solarzelle mit Halbleiterbauelement und Solarzelle**

(71) Anmelder: Scheuten Glasgroep, 5900 AA Venlo (NL)
(72) Erfinder: Scheuten, Jacques, 3680 Maaseik (BE); Geyer, Volker, 41372 Niederkrüchten (DE); Kaas, Patrick, 5632 MN Eindhoven (NL)
(74) Vertreter: Jostarndt, Hans-Dieter, Dr. Dipl.-Phys.

(57) **Zusammenfassung**

Die Erfindung betrifft ein kugel- oder kornförmiges Halbleiterbauelement zur Verwendung in Solarzellen und ein Verfahren zur Herstellung dieses Halbleiterbauelementes. Die Erfindung betrifft ferner eine Solarzelle mit integrierten kugelförmigen Halbleiterbauelementen, ein Verfahren zur Herstellung dieser Solarzelle und ein Photovoltaikmodul mit wenigstens einer Solarzelle.

Das Halbleiterbauelement zeichnet sich dadurch aus, dass auf einem kugel- oder kernförmigen Substratkern eine Rückkontaktund eine I-III-VI-Verbindungshalbleiterschicht abgeschieden sind. Der I-III-VI-Verbindungshalbleiter wird durch Aufbringen von Precursorschichten und eine anschließende Selenisierung oder Sulfurisierung erzeugt. Mehrere der Halbleiterbauelemente werden zur Herstellung einer Solarzelle in eine Trägerschicht eingebracht werden, aus welcher sie auf wenigstens einer Seite herausragen. Die Trägerschicht wird auf einer Seite abgetragen, so dass die Rückkontaktschicht der meisten Halbleiterbauelemente freigelegt ist. Diese Rückkontaktschicht kann in Kontakt mit einem Rückkontakt der Solarzelle gebracht werden, während auf der Seite der nicht bearbeiteten Halbleiterbauelemente ein Vorderkontakt aufgebracht wird.

## Beschreibung

Die Erfindung betrifft ein kugel- oder kornförmiges Halbleiterbauelement zur Verwendung in Solarzellen und ein Verfahren zur Herstellung dieses Halbleiterbauelementes.

Die Erfindung betrifft ferner eine Solarzelle mit integrierten kugel- oder kornförmigen Halbleiterbauelementen und ein Verfahren zur Herstellung dieser Solarzelle.

Die Erfindung betrifft ferner ein Photovoltaikmodul mit wenigstens einer Solarzelle mit integrierten Halbleiterbauelementen.

In photovoltaischen Zellen wird durch Ausnutzung des photovoltaischen Effektes solare Strahlungsenergie in elektrische Energie umgewandelt. Dazu eingesetzte Solarzellen werden vorwiegend aus planaren Wafern hergestellt, in welchen ein konventioneller p/n-Übergang realisiert wird. Zur Herstellung eines p/n-Übergangs und weiterer Funktionsschichten hat sich dabei neben dem Aufbringen und Bearbeiten einzelner durchgehender Schichtflächen das Aufbringen von Halbleitermaterial in kugel- oder kornförmiger Form als zweckmäßig erwiesen, da dies verschieden Vorteile mit sich bringt.

Beispielsweise ist es zur Herstellung von elektronischen Einrichtungen seit langem bekannt, elektronisch aktives Material als Partikel in eine Schicht einzubringen, um die Aktivität des Materials zu erhöhen. Dies ist beispielsweise in der US-Patentschrift US 3,736,476 beschrieben. In einem darin offenbarten Ausführungsbeispiel wird ein Kern und eine den Kern umgebende Schicht so ausgebildet, dass sich ein p/n-Übergang ergibt. Mehrere der so hergestellten Partikel werden so in eine isolierende Trägerschicht eingebracht, dass sie auf beiden Seiten der Schicht aus der Oberfläche herausragen und von weiteren Schichten kontaktiert werden können.

Ferner beschreibt die Deutsche Offenlegungsschrift DE 100 52 914 A1 eine Halbleitereinrichtung, die aus einem Schichtaufbau gebildet wird, der aus einer elektrisch leitfähigen Trägerschicht, einer Isolierschicht, Halbleiterpartikeln und einer elektrisch leitfähigen Deckschicht besteht, wobei die Halbleiterpartikel in die Isolierschicht eingebracht sind und sie sowohl die darunter liegende Trägerschicht als auch die darüber liegende Deckschicht berühren. Die Halbleiterpartikel können beispielsweise aus Silizium oder I-III-VI-Halbleiterpartikeln bestehen, die mit II-VI-Verbindungen beschichtet sind.

Den Hintergrund bei der Verwendung von I-III-VI-Verbindungshalbleitern wie Kupferindiumdiselenid, Kupferindiumsulfid, Kupferindiumgalliumsulfid und Kupferindiumgalliumdieselenid stellen beispielsweise die US-Patentschriften US 4,335,266 (Mickelsen et al) und US 4,581,108 (Kapur) dar, in denen dieser Halbleitertyp und Verfahren zur Herstellung anschaulich beschrieben sind. I-III-VI-Verbindungshalbleiter werden im Folgenden auch als Chalkopyrite oder CIS- bzw. CIGS-Halbleiter bezeichnet.

Es ist ferner bekannt, unabhängige sphärische Halbleiterbauelemente auszubilden, welche vollständige Halbleiter inklusive der erforderlichen Elektroden darstellen. Beispielsweise ist es aus der Europäischen Patentanmeldung EP 0 940 860 A1 bekannt, einen sphärischen Kern durch Maskierungen, Ätzschritte und das Aufbringen von verschiedenen Materialschichten zu einem sphärischen Halbleiterbauelement auszubilden. Derartige Halbleiterbauelemente können als Solarzellen eingesetzt werden, wenn der p/n-Übergang so gewählt ist, dass er einfallendes Licht in Energie umwandeln kann. Ist der p/n-Übergang so ausgebildet, dass er eine angelegte Spannung in Licht umwandeln kann, kann das Halbleiterbauelement als Licht emittierendes Element eingesetzt werden.

Aufgrund der vielseitigen angestrebten Einsatzbereiche derartiger Halbleiterbauelemente müssen die Elemente vollständig unabhängige Bauteile mit Elektrodenanschlüssen darstellen, welche in andere Anwendungen eingebaut werden können. Dies erfordert eine hohe Komplexität der Halbleiterbauelemente und der erforderlichen Herstellungsprozesse. Aufgrund der geringen Abmaße der verwendeten Kugelformen von wenigen Millimetern ist die Herstellung der sphärischen Bauelemente mit allen Funktionsschichten und Bearbeitungsschritten dabei sehr aufwändig.

Aufgabe der Erfindung ist es, ein Halbleiterbauelement mit hoher Aktivität bereitzustellen, das sich zur flexiblen Verwendung in verschiedenen Solarzellen eignet.

Aufgabe der Erfindung ist es ferner, ein effizientes Verfahren zur Herstellung eines Halbleiterbauelementes zur Verwendung in Solarzellen bereitzustellen.

Eine weitere Aufgabe der Erfindung ist es, ein Verfahren zur Einbringung eines Halbleiterbauelementes in eine Solarzelle bereitzustellen.

Ferner ist es Aufgabe der Erfindung, eine Solarzelle mit integrierten Halbleiterbauelementen und ein Photovoltaikmodul mit wenigstens einer Solarzelle bereitzustellen.

Erfindungsgemäß wird diese Aufgabe durch die Merkmale der Hauptansprüche 1, 21, 37 und 45 gelöst. Vorteilhafte Weiterbildungen der Erfindung sind den Unteransprüchen zu entnehmen.

Erfindungsgemäß wird die Aufgabe durch ein kugel- oder kornförmigen Halbleiterbauelement zur Verwendung in einer Solarzelle gelöst. Das Verfahren zur Herstellung eines derartigen Halbleiterbauelementes ist durch das Aufbringen einer leitenden Rückkontaktschicht auf einen kugel- oder kornförmigen Substratkern, das Aufbringen einer ersten Precursorschicht aus Kupfer oder Kupfergallium, das Aufbringen einer zweiten Precursorschicht aus Indium und die Umsetzung der Precursorschichten mit Schwefel und/oder Selen zu einem I-III-VI-Verbindungshalbleiter gekennzeichnet.

Die Umsetzung der Precursorschichten erfolgt in Anwesenheit von Selen und/oder Schwefel und wird als Selenisierung oder Sulfurisierung bezeichnet. Diese Prozesse können auf verschiedene Arten mit auf den jeweiligen Prozess abgestimmten Parametern durchgeführt werden. Zu diesen Parametern zählen beispielsweise Temperatur, Zeit, Atmosphäre und Druck. Die Selenisierung oder Sulfurisierung kann beispielsweise in Dampf, Schmelzen oder Salschmelzen des jeweiligen Umsetzungselementes oder Salzschmelzen mit Beimengungen von Schwefel und/oder Selen erfolgen. Die Elemente Schwefel und Selen können dabei sowohl gleichzeitig als auch nacheinander zur Umsetzung eingesetzt werden. In einem besonders bevorzugten Ausführungsbeispiel der Erfindung erfolgt die Umsetzung in Wasserstoffverbindungen des Selens oder Schwefels.

Um eine I-III-VI-Verbindungshalbleiterschicht mit definierten Eigenschaften zu erhalten, müssen bestimmte Parameter der Precursorschichten eingestellt werden. Dazu gehören neben der Zusammensetzung auch die Dicken der einzelnen Schichten. Dabei sind aufgrund der Kugelform und des damit variierenden Durchmessers gegebenenfalls andere Schichtdickenverhältnisse zu wählen als bei bekannten Verfahren zur Ausbildung von planaren I-III-VI-Verbindungshalbleitern.

Der zu beschichtende Substratkern besteht in einem besonders bevorzugten Ausführungsbeispiel der Erfindung aus Glas, insbesondere aus Kalk-Natron-Glas, da dies eine gute Natriumquelle für den Schichtaufbau darstellt. Der Hauptbestandteil der leitenden Rückkontaktschicht ist vorzugsweise Molybdän. In einem besonders bevorzugten Ausführungsbeispiel der Erfindung enthält die Rückkontaktschicht zur Haftungsverbesserung bis zu 20 Gew.% Gallium. Die einzelnen Schichten können jeweils durch PVD-Verfahren wie Sputtern oder Aufdampfen oder CVD-Verfahren aufgebracht werden.

Die Precursorschichten können vor der Umsetzung zu einem I-III-VI-Verbindungshalbleiter bei Temperaturen von typischerweise > 220 °C legiert werden. Nach der Umsetzung des Precursorschichtsystems zu einem I-III-VI-Verbindungshalbleiter können weitere Bearbeitungsschritte oder Beschichtungen durchgeführt werden. Dazu zählt beispielsweise eine Behandlung mit KCN-Lösung (z.B. 10% KCN Lösung in alkalischer 0,5% KOH-Lösung) zur Entfernung störender Oberflächenschichten wie Kupfer-Schwefel Verbindungen. Ferner können eine Bufferschicht, eine hochohmige und eine niedrigohmige ZnO-Schicht abgeschieden werden.

Das erfindungsgemäße kugel- oder kornförmige Halbleiterbauelement zur Verwendung in Solarzellen weist somit einen kugel- oder kornförmigen Substratkern auf, der wenigstens mit einer Rückkontaktschicht und einem I-III-VI-Verbindungshalbleiter beschichtet ist. Der Substratkern besteht vorzugsweise aus Glas, Metall oder Keramik und der Durchmesser des Substratkerns liegt in der Größenordnung von 0,05- 1mm. Besonders zweckmäßig hat sich ein Durchmesser von 0,2mm erwiesen. Die Dicke der Rückkontaktschicht liegt in der Größenordnung von 0,1-1µm. Die I-III-VI-Verbindungshalbleiterschicht besteht beispielsweise aus Kupferindiumdiselenid, Kupferindiumsulfid, Kupferindiumgalliumsulfid oder Kupferindiumgalliumdiselenid. Die Dicke dieser Schicht liegt in der Größenordnung von 1-3µm.

Mit den beschriebenen Verfahrensschritten hergestellte kugel- oder kornförmige Halbleiterbauelemente stellen Elemente zur weiteren Verwendung bei der Herstellung von Solarzellen dar. Die Vorteile derartiger Halbleiterbauelemente zur Verwendung in Solarzellen liegen beispielsweise darin, dass ein I-III-VI-Verbindungshalbleiter hergestellt werden kann, der sich zur Einbringung in unterschiedliche Solarzellen eignet. Dies beinhaltet unter anderem unterschiedliche Abmessungen von Solarzellen. Die Herstellung von flächigen Solarzellen mit I-III-VI-Verbindungshalbleitern erfolgt herkömmlicherweise in Reaktoren, die zur Einhaltung bestimmter Parameter genau auf die Größe der angestrebten Solarzellen angepasst sein müssen. Großflächige Solarzellenstrukturen erfordern somit auch entsprechend große Reaktoren, in denen beispielsweise bei einer Umsetzung unter Wärmeeinfluss große Gesamtmassen erwärmt und wieder abgekühlt werden müssen. Dies führt zu einem hohen Energiebedarf. Die Herstellung von kugel- oder kornförmigen Halbleiterbauelementen zur späteren Verarbeitung in Solarzellen benötigt dagegen weitaus weniger Energie, da in den entsprechenden Reaktoren vergleichsweise geringe Volumina umgesetzt werden müssen.

Ein weiterer Vorteil ist in der höheren Flexibilität bei der Herstellung zu sehen. Sollen beispielsweise bei herkömmlichen Solarzellenflächen größere oder kleinere Strukturen in einem Reaktor umgesetzt werden, muss ein entsprechender neuer Reaktor bereitgestellt werden, um die erforderlichen Parameter genau einstellen zu können. Dies ist sehr kosteninteniv. Die Herstellung solcher herkömmlichen Dünnschichtmodule ist somit begrenzt durch die zur Anwendung kommenden Apparaturen zur Fertigung der Halbleiterschicht. Bei der Herstellung der erfindungsgemäßen kugelförmigen Halbleiterbaulemente kann dagegen ein bestehender Reaktor durch weitere ergänzt werden, um die nötige Menge an Bauelementen zu produzieren. Die spätere Herstellung von Solarzellen, für die kein Reaktor erforderlich ist, sondern lediglich Anlagen zum Aufbringen von weiteren Schichten, ist also wesentlich vereinfacht.

Durch die Kugelform können ferner zweckmäßige Schichtsysteme realisiert werden, welche mit flächigen Halbleiterstrukturen unter Umständen nicht erreichbar sind. Beispielsweise ist die erforderliche Dicke der abgeschiedenen Schichten geringer. Dadurch wird beispielsweise der Einsatz einer Rückkontaktschicht aus Molybdän-Galliumschicht möglich, ohne dass der Widerstand der Schicht zu groß wird, wie es bei flächigen Strukturen der Fall ist.

Mit dem erfindungsgemäßen Verfahren zur Herstellung einer Solarzelle mit integrierten kugel- oder kornförmigen Halbleiterbauelementen werden Halbleiterbauelemente in einer Solarzelle weiterverarbeitet. Das Verfahren sieht das Einbringen von kugelförmigen Halbleiterbauelementen in eine isolierende Trägerschicht vor, wobei die Halbleiterbauelemente wenigstens auf einer Seite der Trägerschicht aus der Oberfläche der Trägerschicht herausragen, und die kugel- oder kornförmigen Halbleiterbauelemente jeweils aus einem Substratkern bestehen, der wenigstens mit einer leitenden Rückkontaktschicht und einer I-III-VI-Verbindungshalbleiterschicht beschichtet ist. Teile der Halbleiterbauelemente werden auf einer Seite der Trägerschicht abgetragen, so dass vorzugsweise eine Fläche der Rückkontaktschicht mehrerer Bauelemente freigelegt ist. Auf diese Seite der Trägerschicht kann danach eine Rückkontaktschicht aufgebracht werden, die in Kontakt mit den freien Rückkontaktflächen der Halbleiterbauelemente steht. Auf die andere Seite der Trägerschicht wird eine Vorderkontaktschicht aufgebracht. Neben der Vorderkontaktschicht und der Rückkontaktschicht können weitere Funktionsschichten abgeschieden werden.

Die Halbleiterbauelemente werden in einem besonders bevorzugten Ausführungsbeispiel der Erfindung durch Streuen, Stäuben und/oder Drucken auf die Trägerschicht aufgebracht und danach in die Trägerschicht eingedrückt, so dass sie zu einem bestimmten Grad in die Trägerschicht eingebettet sind. Handelt es sich bei der Trägerschicht um eine thermoplastische Folie, die auf einen weichen Untergrund gelegt wird, können die Halbleiterbauelemente beispielsweise so tief in die Schicht gedrückt werden, dass sie in den weichen Untergrund eindringen und somit auf beiden Seiten der Trägerschicht herausragen.

Die Trägerschicht kann auch als Matrix mit Aussparungen ausgebildet sein, in welche die Halbleiterbauelemente eingebracht und gegebenenfalls befestigt werden. Dies kann beispielsweise durch einen Erwärmungs- und/oder Pressvorgang erfolgen.

Beim Abtragen von Teilen der Halbleiterbauelemente kann zusätzlich ein Teil der Trägerschicht mit abgetragen werden. Das Abtragen kann beispielsweise durch Schleifen, Polieren, Ätzen, thermischen Energieeintrag oder photolithographische Prozesse erfolgen, während die Rückkontaktschicht und die Vorderkontaktschicht jeweils durch PVD- oder CVD-Verfahren abgeschieden werden können. Werden als Rückkontakt- oder Vorderkontaktschicht beispielsweise leitfähige Polymeren eingesetzt, haben sich Verfahren wie das Aufpinseln oder Aufsprühen als vorteilhaft erwiesen.

Die erfindungsgemäße Solarzelle mit integrierten kugel- oder kornförmigen Halbleiterbauelementen weist somit eine isolierende Trägerschicht auf, in welche die Halbleiterbauelemente eingebracht sind, wobei die Halbleiterbauelemente wenigstens auf einer Seite der Trägerschicht aus der Schicht herausragen. Sie weist ferner eine Vorderkontaktschicht auf der einen und eine Rückkontaktschicht auf der anderen Seite auf. Auf der Seite der Rückkontaktschicht weisen mehrere Halbleiterbauelemente eine Fläche auf, die frei von I-III-VI-Verbindungshalbleiter ist und somit die Rückkontaktschicht des Halbleiterbauelementes freigibt. Diese Flächen stehen mit der Rückkontaktschicht der Solarzelle in direktem Kontakt.

In einem besonders bevorzugten Ausführungsbeispiel der Erfindung besteht die Trägerschicht aus einem isolierenden Material wie beispielsweise einem Polymer. Die kugelförmigen Halbleiterbauelemente wurden vorzugsweise nach dem erfindungsgemäßen Verfahren hergestellt, und die Vorderkontaktschicht besteht beispielsweise aus einem TCO (Transparent Conductive Oxide). Die Rückkontaktschicht besteht aus einem leitenden Material wie einem Metall, einem TCO oder einem Polymer mit leitfähigen Partikeln. Die Solarzelle kann neben der Vorderkontaktschicht und der Rückkontaktschicht weitere Funktionsschichten aufweisen.

Sind alle Verfahrensschritte abgeschlossen, ist eine Solarzelle mit integrierten Halbleiterbauelementen erzeugt, die insbesondere gegenüber planaren Halbleiterstrukturen verschiedene Vorteile aufweist. Der wesentliche Vorteil neben der vereinfachten Herstellung liegt in den gekrümmten Oberflächen der Halbleiterbauelemente, auf welche einfallendes Licht unabhängig von der Einfallsrichtung auftreffen kann. So kann auch diffuse Lichteinstrahlung besser zur Stromerzeugung genutzt werden.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: in Abbildung (a) ein besonders bevorzugtes Ausführungsbeispiel eines Schichtaufbaus zur Herstellung ein kugelförmigen Halbleiterbauelements und in Abbildung (b) ein mit dem erfindungsgemäßen Verfahren hergestelltes Halbleiterbauelement; und
- Fig. 2: in den Abbildungen (a)-(d) die erfindungsgemäßen Verfahrensschritte bei der Einbringung eines kugelförmigen Halbleiterbauelementes in eine Solarzelle.

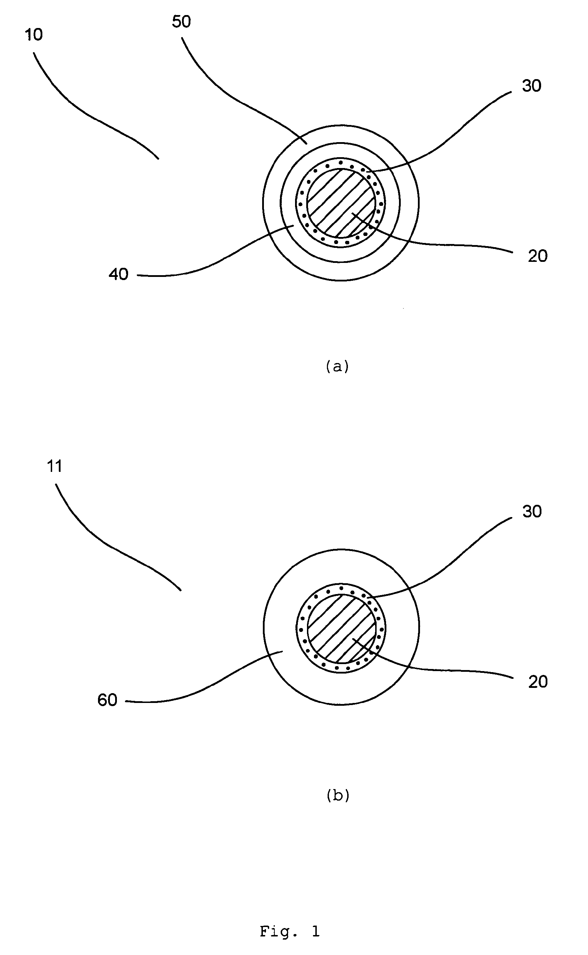

In Fig. 1 ist in Abbildung (a) ein besonders bevorzugtes Ausführungsbeispiel eines Schichtaufbaus 10 zur Herstellung eines kugel- oder kornförmigen Halbleiterbauelements 11 dargestellt. Der Schichtaufbau 10 ist auch als Precursorschichtaufbau für die spätere Umsetzung zu einem I-III-VI-Verbindungshalbleiter anzusehen. Im ersten Schritt des erfindungsgemäßen Verfahrens zur Herstellung eines kugelförmigen Halbleiterbauelements 11 wird ein kugelförmiger Substratkern 20 mit einem Rückkontakt 30 beschichtet. Das kugelförmige Substrat besteht vorzugsweise aus Glas, es kann sich jedoch auch um andere Materialien wie Metalle oder Keramiken handeln. Beim Einsatz von Glas kann beispielsweise Kalk-Natron-Glas verwendet werden, was eine gute Natriumquelle für den späteren Schichtaufbau darstellt. Es können auch andere Glaszusammensetzungen zur Anwendung kommen.

Das Substrat ist im Wesentlichen kugelförmig, die Form kann jedoch auch von der reinen Kugelform abweichen. Je nach Herstellungsprozess sind die hervorgehenden Kugeln auch als kornförmig zu bezeichnen. Es können auch Hohlkörper aus den genannten Materialien eingesetzt werden. Der Durchmesser der Kugeln liegt in der Größenordnung von 0,05-1mm, wobei vorzugsweise ein Durchmesser von etwa 0,2mm gewählt wird.

Der Rückkontakt 30 wird so auf das kugelförmige Substrat aufgebracht, dass die gesamte Oberfläche der Kugel beschichtet ist. Bei dem Material für den Rückkontakt handelt es sich vorzugsweise um Molybdän, es können jedoch auch andere geeignete leitfähige Materialien wie beispielsweise Wolfram oder Vanadium verwendet werden.

Die Beschichtung des Substratkerns 20 kann durch PVD-Verfahren wie dem Sputtern oder Aufdampfen erfolgen. Auch CVD-Verfahren können angewendet werden, wobei festgestellt werden kann, dass das Sputtern einer Vielzahl von kleinen Substratkugeln ein sehr zeitaufwändiger Prozess ist, der sich im Hinblick auf den möglichen Durchsatz weniger eignet als andere Verfahren. Die Dicke der Rückkontaktschicht liegt in der Größenordnung von 0,1-1µm.

Um die Haftung darauf folgender Schichten zu der Rückkontaktschicht zu verbessern, kann auf die Molybdänschicht eine Galliumschicht aufgebracht werden. In einem besonders bevorzugten Ausführungsbeispiel der Erfindung wird das Gallium zur Haftungserhöhung in die Molybdänschicht eingebracht. Dies kann einen Galliumgehalt von bis zu 20 Gew.% beinhalten. Diese Lösung wird in der Praxis bei flächigen Solarzellen herkömmlicherweise vermieden, da es den Widerstand des Rückkontaktes nachteilig erhöht. Bei der Herstellung der erfindungsgemäßen Halbleiterbauelemente hat sich eine Gallium-Molybdänschicht jedoch als vorteilhaft erwiesen, da dünnere Schichten als bei flächigen Halbleitern realisiert werden können, deren vergrößerter Widerstand keine gravierenden Nachteile mit sich bringt.

Als Halbleiterverbindung wird erfindungsgemäß ein I-III-VI-Verbindungshalbleiter gewählt. Zu diesen auch als Chalkopyrite bezeichneten Halbleitern zählen beispielsweise Kupferindiumdiselenid, Kupferindiumsulfid, Kupferindiumgalliumsulfid und Kupferindiumgalliumdieselenid.

Zur Herstellung einer derartigen CuGa/InS/Se₂-Schicht auf dem Substrat werden zuerst Precursorschichten aus Kupfer, Gallium und/oder Indium aufgebracht, die in einem anschließenden Selenisierungs- oder Sulfurisierungsprozess zu dem angestrebten Halbleiter umgewandelt werden. Die Precursorschichten können mit den gleichen Verfahren wie der Rückkontakt aufgebracht werden, so dass auch hier PVD-Verfahren wie Sputtern und Verdampfen oder CVD-Verfahren zur Anwendung kommen können. Als erste Precursorschicht 40 wird das kugelförmige Substrat in einem besonders bevorzugten Ausführungsbeispiel der Erfindung mit Kupfer beschichtet. Um die Haftung zwischen dieser ersten Schicht und dem Rückkontakt zu verbessern, kann vorher eine dünne Kupfer-Gallium-Schicht als Haftvermittler aufgebracht werden.

In einem ersten Ausführungsbeispiel der Erfindung wird auf die Kupferschicht eine zweite Precursorschicht 50 in Form von Indium abgeschieden. Ein abwechselndes Aufbringen von Cu/In Schichtpaketen (z.B. Cu/In/Cu/In) ist ebenfalls möglich. Die CU/In-Schichten werden anschließend mit Schwefel zu CuInS geschwefelt werden und eine sogenannte CIS-Schicht gebildet. Die aus den Precursorn und dem Sulfurisierungsprozess resultierende CIS-Schicht 60 ist auf dem Halbleiterbauelement 11 in der Abbildung (b) dargestellt. Das Precursorschichtsystem aus Kupfer und Indium kann vor der Sulfurisierung optional bei einer erhöhten Temperatur von typischerweise T > 220° legiert werden, was für die Haftung und spätere Umsetzung mit Selen und/oder Schwefel vorteilhaft ist. Dieser Schritt ist jedoch nicht zwingend erforderlich.

Die Schichtdicken der Cu- und In-Schicht werden durch die angestrebte Schichtdicke des CIS-Halbleiters bestimmt. Vorzugsweise liegt die Schichtdicke der CIS-Schicht 60 in der Größenordnung von 1-3µm. Es hat sich dazu als zweckmäßig erwiesen, dass das Atomverhältnis Cu/In in der Größenordnung von 1-2 liegt. Besonders bevorzugt sind Atomverhältnisse von Kupfer zu Indium zwischen 1,2-1,8.

In einem zweiten Ausführungsbeispiel der Erfindung wird auf die Rückkontaktschicht 30 als erste Precursorschicht 40 eine Kupfer- oder eine Kupfer-Gallium-Schicht aufgebracht. Auf diese erste Precursorschicht folgt wiederum ein zweiter Precursor 50 in Form einer Indiumschicht, wobei die beiden Schichten anschließend zu CuIn/GaSe₂ selenisiert werden und eine CIGS-Schicht bilden. Das Kupfer-Indium/Gallium-Schichtsystem kann auch hier optional bei einer erhöhten Temperatur von typischerweise T > 220° legiert werden.

In diesem Ausführungsbeispiel sind die Schichtdicken ebenfalls abhängig von dem angestrebten Atomverhältnis Cu/(In+Ga) nach der Selenisierung. Es hat sich als zweckmäßig erweisen, dass dieses Verhältnis < 1 ist. Die Schichtdicke der CIGS-Schicht nach der Selenisierung liegt vorzugsweise in der Größenordnung von 1-3µm. Es hat sich herausgestellt, dass der Kupfergehalt der fertigen CIGS-Schicht kleiner als das stöchiometrisch notwendige Maß eingestellt werden kann.

Die Umsetzung der mit den Precursorn beschichteten Kugeln kann durch Selenisierung mit Selen und/oder Sulfurisierung mit Schwefel erfolgen. Dabei können verschiedene Verfahren zur Anwendung kommen. In einem besonders bevorzugten Ausführungsbeispiel der Erfindung werden die Kugeln im Vakuum oder unter Atmosphärendruck mit einem Dampf des jeweiligen Elementes (Se und/oder S) umgesetzt. Diese Umsetzung erfolgt mit bestimmten Parametern wie beispielsweise Temperatur, Zeit, Prozessdauer, Druck und Partialdruck. Die Umsetzung kann ferner in einer Schmelze der Elemente erfolgen. Eine weitere Möglichkeit der Umsetzung stellt die Salzschmelze dar, welche S und/oder Se beinhaltet.

In einem weiteren Ausführungsbeispiel der Erfindung werden die Kugeln in Wasserstoffverbindungen des Schwefels und/oder des Selens umgesetzt. Dies kann beispielsweise unter Atmosphärendruck oder bei einem Druck kleiner als Atmosphärendruck erfolgen. Bei der Umsetzung können sowohl Schwefel als auch Selen nacheinander oder gleichzeitig zum Einsatz kommen.

In einem besonders bevorzugten Ausführungsbeispiel der Erfindung werden als nächster Prozessschritt nach der Umsetzung der Kugeln nachteilig wirkende Oberflächenschichten entfernt. Dabei kann es sich beispielsweise um CuS-Verbindungen handeln, die beim Umsetzungsprozess entstanden sind. Eine Möglichkeit der Entfernung derartiger Schichten liegt in der Behandlung mit KCN-Lösung. Wurde eine Sulfurisierung durchgeführt, ist dieser Behandlungsschritt notwendig, während er nach einer Selenisierung als optional angesehen werden kann.

In einem bevorzugten Ausführungsbeispiel wird im nächsten Schritt eine Bufferschicht auf den CIS- oder CIGS-Halbleiter abgeschieden. Als Schichtmaterialien können beispielsweise CdS, ZnS, ZnSe, ZnO oder CdZnS verwendet werden. Weitere mögliche Materialien sind in In-Se-Verbindungen oder In-S-Verbindungen zu sehen. Diese Bufferschichten können durch Beschichtungsverfahren wie CVD, PVD, naßchemisch (chemical bath deposition) oder andere geeignete Methoden abgeschieden werden. Als besonders vorteilhaft hat sich die Abscheidung durch Chemical Bath Deposition erwiesen. Die Dicke der Bufferschicht liegt vorzugsweise in der Größenordnung von 10-200nm.

In einem weiteren besonders bevorzugten Ausführungsbeispiel der Erfindung wird im nächsten Schritt hochohmiges ZnO (i-ZnO) auf dem Schichtaufbau abgeschieden. Für die Abscheidung dieser Schicht können Verfahren wie PVD (reaktiv oder keramisch), CVD oder Chemical Bath Deposition eingesetzt werden. Die Dicke der Schicht liegt vorzugsweise in der Größenordnung von 10-100nm.

Nach der Abscheidung von hochohmigen ZnO (ca. 50nm) wird in einem besonders bevorzugten Ausführungsbeispiel der Erfindung eine weitere Schicht niedrigohmiges ZnO (ZnO:Al) abgeschieden. Hier können die gleichen Depositionsmethoden wie bei hochohmigem ZnO zur Anwendung kommen. Die Dicke dieser Schicht (TCO) liegt in der Größenordnung von 0,1-2µm.

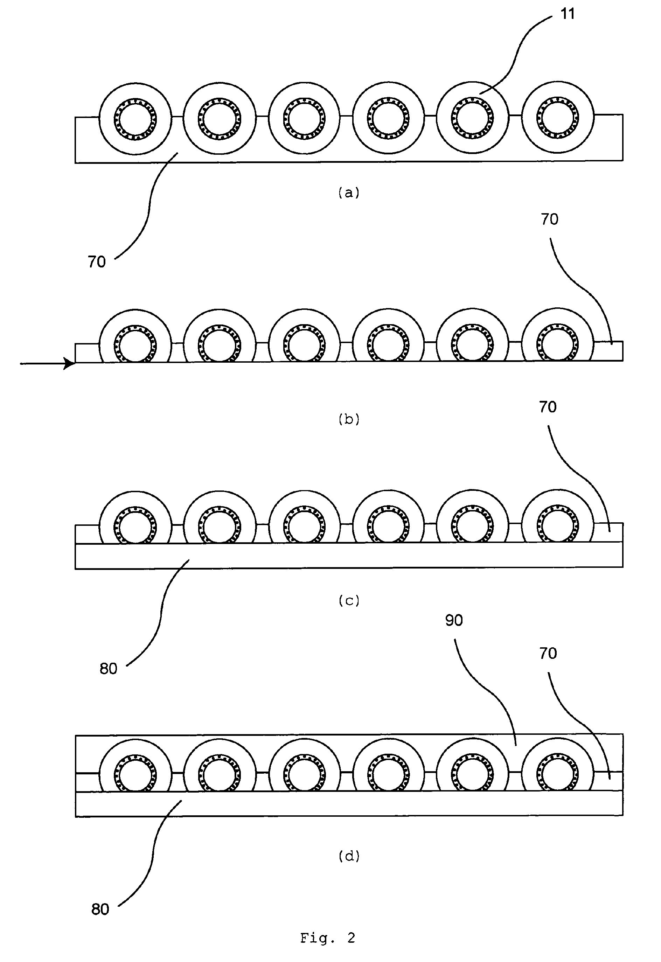

Mit den beschriebenen Verfahrensschritten hergestellte kugelförmige Halbleiterbauelemente stellen Elemente zur weiteren Verwendung bei der Herstellung von Solarzellen dar. Die erfindungsgemäßen Halbleiterbauelemente können auf verschiedene Arten in Solarzellen weiterverarbeitet werden. Beispielsweise werden die kugelförmigen Halbleiterbauelemente in einem weiteren Aspekt der Erfindung in eine Solarzelle eingebettet, wie es in den Abbildungen (a)-(d) der Fig. 2 dargestellt ist.

In der Abbildung (a) der Fig. 2 ist die Einbringung der Halbleiterbauelemente 11 in eine isolierende Trägerschicht 70 dargestellt. Dabei hat es sich als zweckmäßig erwiesen, als Trägerschicht eine flexible Folie zu verwenden. Die Trägerschicht besteht vorzugsweise aus einem thermoplastischen Polymer, bei dem es sich beispielsweise um ein Polymer aus der Gruppe der Polycarbonate oder Polyester handeln kann. Auch prepolymerisierte Harze aus der Gruppe der Epoxide, Polyurethane, Polyacryle und/oder Polyimide können verwendet werden. Desweiteren kann ein flüssiges Polymer verwendet werden, in welches die Kugeln eingedrückt werden und welches danach aushärtet.

Die Halbleiterbauelemente 11 werden vorzugsweise so in die Trägerschicht 70 eingebracht, dass sie wenigstens auf einer Seite der Trägerschicht aus der Oberfläche der Schicht herausragen. Die Partikel können dazu beispielsweise durch Streuen, Stäuben und/oder Drucken aufgebracht und danach eingedrückt werden. Zum Eindrücken der Körper in die Trägerschicht kann diese beispielsweise erwärmt werden.

In einem weiteren Ausführungsbeispiel der Erfindung werden die Partikel in eine vorgefertigte Matrix einer Trägerschicht eingebracht, in der sich Aussparungen befinden, in welche die Partikel eingefügt werden. Zur Befestigung der Körper an der Trägerschicht kann ein Erwärmungs- und/oder Pressvorgang durchgeführt werden.

Sollen die Halbleiterbauelemente auf beiden Seiten der Trägerschicht herausragen, kann sich die Trägerschicht beim Einbringen der Bauelemente beispielsweise auf einer flexiblen Unterlage befinden, so dass die Halbleiterbauelemente so weit in die Trägerschicht eingedrückt werden können, dass Teile davon auf der Unterseite der Trägerschicht austreten.

In einem besonders bevorzugten Ausführungsbeispiel der Erfindung werden als nächster Schritt Teile der Halbleiterbauelemente auf einer Seite der Trägerschicht abgetragen. Dabei können auch Teile der Trägerschicht abgetragen werden. Dies ist in der Abbildung (b) der Fig. 2 durch einen Pfeil dargestellt. Die Trägerschicht 70 wird dabei vorzugsweise bis zu einer Schichtdicke abgetragen, bei der Teile der eingebrachten Körper mit abgetragen werden. In dem dargestellten Ausführungsbeispiel erfolgt ein Abtrag bis auf die gepunktet dargestellte Rückkontaktschicht 30 des Halbleiterbauelements 11. Falls die Halbleiterbauelemente so in die Trägerschicht eingebracht wurden, dass sie auf beiden Seiten der Schicht herausragen, ist es auch möglich, die Halbleiterbauelemente auf einer Seite ohne zusätzliche Abtragung der Trägerschicht zu bearbeiten, so dass die Halbleiterbauelemente nach der Abtragung entweder weiter aus der Trägerschicht herausragen oder mit ihr abschließen.

Der Abtrag der Halbleiterkörper bzw. der Trägerschicht kann auch zu anderen Zeitpunkten erfolgen, die vor der Aufbringung eines späteren Rückkontakts 80 auf dieser Seite liegen. Der Abtrag der Halbleiterbauelemente und/oder der Trägerschicht kann durch mechanische Verfahren wie das Schleifen oder Polieren, Ätzen, thermischen Energieeintrag beispielsweise durch Laser oder Strahlung oder photolithographische Prozesse erfolgen.

In einem weiteren Verfahrensschritt wird eine leitende Rückkontaktschicht 80 auf die Seite mit den abgetragenen Halbleiterbauelementen aufgebracht. Als leitendes Material für diesen Rückkontakt können beispielsweise Stoffe aus diversen Polymerklassen verwendet werden. Besonders geeignet sind Epoxidharze, Polyurethane, und/oder Polyimide, die mit geeigneten leitfähigen Partikeln wie Kohlenstoff, Indium, Nickel, Molybdän, Eisen, Nickelchrom, Silber, Aluminium und/oder entsprechenden Legierungen bzw. Oxiden versehen sind. Eine weitere Möglichkeit stellen intrinsische leitfähige Polymere dar. Dazu zählen beispielsweise Polymere aus der Gruppe der PANis. Zur Anwendung können ferner Materialien wie TCOs oder geeignete Metalle kommen. Der Rückkontakt kann bei TCOs und Metallen mit PVD- oder CVD-Verfahren aufgebracht werden.

Im einem weiteren Verfahrensschritt wird eine leitende Vorderkontaktschicht 90 auf die Seite der Trägerschicht aufgebracht, auf welcher keine Halbleiterbauelemente abgetragen wurden. Auch dies kann mit Methoden wie PVD oder CVD erfolgen. Als leitendes Material des Vorderkontakts können beispielsweise diverse TCOs (Transparent Conductive Oxides) eingesetzt werden.

Vor oder Nach der Abscheidung eines Vorder- und eines Rückkontaktes können weitere Funktionsschichten abgeschieden werden. Die Wahl der zusätzlichen Funktionsschichten ist insbesondere abhängig von den verwendeten Halbleiterbauelementen. Funktionsschichten wie z.B. Bufferschichten, welche bereits auf den Halbleiterkörpern abgeschieden wurde, müssen gegebenenfalls zur Herstellung der Solarzelle mit integrierten Halbleiterbauelementen nicht mehr abgeschieden werden. Nach allen erforderlichen Abscheidungs- und Bearbeitungsschritten ist eine Solarzelle entstanden, aus welcher ein Photovoltaikmodul erzeugt werden kann. Eine oder mehrere der Solarzellen können beispielsweise in Serie verschaltet und zu einem Modul zusammengefügt werden, an dem erzeugter Strom abgegriffen wird.

### Bezugszeichenliste:

- 10: Schichtaufbau, Precursorschichtaufbau
- 11: Halbleiterbauelement
- 20: Substrat, Substratkern
- 30: Rückkontaktschicht eines Halbleiterbauelementes
- 40: Erste Precursorschicht
- 50: Zweite Precursorschicht
- 60: I-III-VI-Verbindungshalbleiter, CIS- oder CIGS-Schicht
- 70: Trägerschicht, isolierend
- 80: Rückkontaktschicht einer Solarzelle
- 90: Vorderkontaktschicht einer Solarzelle

## Patentansprüche

1. Verfahren zur Herstellung eines kugel- oder kornförmigen Halbleiterbauelements (11) zur Verwendung in einer Solarzelle, **gekennzeichnet durch** folgenden Schritte:
- Aufbringen einer leitenden Rückkontaktschicht (30) auf einen kugel- oder kornförmigen Substratkern (20);
- Aufbringen einer ersten Precursorschicht (40) aus Kupfer oder Kupfergallium;
- Aufbringen einer zweiten Precursorschicht (50) aus Indium;
- Umsetzung der Precursorschichten (40) und (50) mit Schwefel und/oder Selen zu einem I-III-VI-Verbindungshalbleiter.

2. Verfahren nach Anspruch 1, **dadurch gekennzeichnet, dass** der Hauptbestandteil der leitenden Rückkontaktschicht (30) Molybdän ist.

3. Verfahren nach Anspruch 2, **dadurch gekennzeichnet, dass** die leitende Rückkontaktschicht (30) zur Haftungsverbesserung bis zu 20 Gew.% Gallium enthält.

4. Verfahren nach einem oder mehreren der vorangegangenen Ansprüche, **dadurch gekennzeichnet, dass** die Schichten (30;40;50) jeweils durch PVD- und/oder CVD-Verfahren aufgebracht werden.

5. Verfahren nach einem oder mehreren der vorangegangenen Ansprüche, **dadurch gekennzeichnet, dass** ein Schichtaufbau (10) aus Precursorschichten (40;50) vor der Umsetzung zu einem I-III-VI-Verbindungshalbleiter legiert wird.

6. Verfahren nach Anspruch 5, **dadurch gekennzeichnet, dass** ein Schichtaufbau (10) aus Precursorschichten (40;50) vor der Umsetzung zu einem I-III-VI-Verbindungshalbleiter bei einer Temperatur T > 220 °C legiert wird.

7. Verfahren nach einem oder mehreren der vorangegangenen Ansprüche, **dadurch gekennzeichnet, dass** die Umsetzung des Schichtaufbaus (10) aus Precursorschichten (40;50) zu einem I-III-VI-Verbindungshalbleiter in Dampf des Umsetzungselementes Schwefel und/oder Selen erfolgt.

8. Verfahren nach Anspruch 7, **dadurch gekennzeichnet, dass** die Umsetzung des Schichtaufbaus (10) unter Atmosphärendruck erfolgt.

9. Verfahren nach Anspruch 7, **dadurch gekennzeichnet, dass** die Umsetzung des Schichtaufbaus (10) unter Vakuum erfolgt.

10. Verfahren nach einem oder mehreren der vorangegangenen Ansprüche, **dadurch gekennzeichnet, dass** die Umsetzung des Schichtaufbaus (10) aus Precursorschichten (40;50) zu einem I-III-VI-Verbindungshalbleiter in einer Schmelze des Umsetzungselementes Schwefel und/oder Selen erfolgt.

11. Verfahren nach einem oder mehreren der vorangegangenen Ansprüche, **dadurch gekennzeichnet, dass** die Umsetzung des Schichtaufbaus (10) aus Precursorschichten (40;50) zu einem I-III-VI-Verbindungshalbleiter in einer Salzschmelze mit Beimengungen des Umsetzungselementes Schwefel und/oder Selen erfolgt.

12. Verfahren nach einem oder mehreren der vorangegangenen Ansprüche, **dadurch gekennzeichnet, dass** die Umsetzung des Schichtaufbaus (10) aus Precursorschichten (40;50) zu einem I-III-VI-Verbindungshalbleiter in Wasserstoffverbindungen des Umsetzungselementes Schwefel und/oder Selen erfolgt.

13. Verfahren nach Anspruch 12, **dadurch gekennzeichnet, dass** die Umsetzung des Schichtaufbaus (10) unter Atmosphärendruck erfolgt.

14. Verfahren nach Anspruch 12, **dadurch gekennzeichnet, dass** die Umsetzung des Schichtaufbaus (10) unter einem Druck kleiner als Atmosphärendruck erfolgt.

15. Verfahren nach einem oder mehreren der vorangegangenen Ansprüche, **dadurch gekennzeichnet, dass** nach der Umsetzung des Schichtsystems (10) zu einem I-III-VI-Verbindungshalbleiter eine Behandlung mit KCN-Lösung durchgeführt wird.

16. Verfahren nach einem oder mehreren der vorangegangenen Ansprüche, **dadurch gekennzeichnet, dass** nach der Umsetzung des Schichtsystems (10) zu einem I-III-VI-Verbindungshalbleiter eine Bufferschicht abgeschieden wird.

17. Verfahren nach einem oder mehreren der vorangegangenen Ansprüche, **dadurch gekennzeichnet, dass** nach der Umsetzung des Schichtsystems (10) zu einem I-III-VI-Verbindungshalbleiter eine hochohmige ZnO-Schicht abgeschieden wird.

18. Verfahren nach Anspruch 17, **dadurch gekennzeichnet, dass** nach der hochohmigen ZnO-Schicht eine niedrigohmige ZnO-Schicht abgeschieden wird.

19. Verfahren nach einem oder mehreren der vorangegangenen Ansprüche 16 bis 18, **dadurch gekennzeichnet, dass** die Schicht (hier meine ich Bufferschicht, und/oder die hochohmige und die niedrigohmige Schicht) durch PVD- oder CVD-Verfahren abgeschieden wird.

20. Verfahren nach Anspruch 19, **dadurch gekennzeichnet, dass** die Schicht durch Chemical Bath Deposition abgeschieden wird.

21. Kugel- oder kornförmiges Halbleiterbauelement zur Verwendung in Solarzellen, **dadurch gekennzeichnet, dass** das Halbleiterbauelement (11) einen kugel- oder kornförmigen Substratkern (20) aufweist, der wenigstens mit einer Rückkontaktschicht (30) und einem I-III-VI-Verbindungshalbleiter beschichtet ist.

22. Halbleiterbauelement nach Anspruch 21, **dadurch gekennzeichnet, dass** der Substratkern (20) aus Glas, Metall oder Keramik besteht.

23. Halbleiterbauelement nach Anspruch 22, **dadurch gekennzeichnet, dass** der Substratkern (20) aus Kalk-Natron-Glas besteht.

24. Halbleiterbauelement nach einem oder mehreren der Ansprüche 21 bis 23, **dadurch gekennzeichnet, dass** der Durchmesser des Substratkerns (20) in der Größenordnung von 0,1 -1mm, insbesondere bei etwa 0,2mm, liegt.

25. Halbleiterbauelement nach einem oder mehreren der Ansprüche 21 bis 24, **dadurch gekennzeichnet, dass** die Dicke der Rückkontaktschicht (30) in der Größenordnung von 0,1-1µm liegt.

26. Halbleiterbauelement nach einem oder mehreren der Ansprüche 21 bis 25, **dadurch gekennzeichnet, dass** der Hauptbestandteil der Rückkontaktschicht (30) Molybdän ist.

27. Halbleiterbauelement nach einem oder mehreren der Ansprüche 17 bis 22, **dadurch gekennzeichnet, dass** die Rückkontaktschicht (30) zur Haftungsverbesserung bis zu 20 Gew.% Gallium enthält.

28. Halbleiterbauelement nach einem oder mehreren der Ansprüche 21 bis 27, **dadurch gekennzeichnet, dass** die I-III-VI-Verbindungshalbleiterschicht (60) aus einer Verbindung aus der Gruppe de Kupferindiumsulfide, Kupferindiumdiselenide, Kupferindiumgalliumsulfide oder Kupferindiumgalliumdiselenide besteht.

29. Halbleiterbauelement nach einem oder mehreren der Ansprüche 21 bis 28, **dadurch gekennzeichnet, dass** die Dicke der I-III-VI-Verbindungshalbleiterschicht (60) in der Größenordnung von 1-3µm liegt.

30. Halbleiterbauelement nach einem oder mehreren der Ansprüche 21 bis 29, **dadurch gekennzeichnet, dass** das Halbleiterbauelement (11) oberhalb der I-III-VI-Verbindungshalbleiterschicht (60) eine Bufferschicht aufweist.

31. Halbleiterbauelement nach Anspruch 30, **dadurch gekennzeichnet, dass** die Bufferschicht aus einem Material der Gruppe CdS, ZnS, ZnSe, ZnO, Indiumselenverbindungen oder Indiumschwefelverbindungen besteht.

32. Halbleiterbauelement nach einem oder beiden der Ansprüche 30 und 31, **dadurch gekennzeichnet, dass** die Dicke der Bufferschicht in der Größenordnung von 20-200nm liegt.

33. Halbleiterbauelement nach einem oder mehreren der Ansprüche 21 bis 32, **dadurch gekennzeichnet, dass** das Halbleiterbauelement oberhalb der I-III-VI-Verbindungshalbleiterschicht (60) eine hochohmige und eine niedrigohmige ZnO-Schicht aufweist.

34. Halbleiterbauelement nach Anspruch 33, **dadurch gekennzeichnet, dass** die Dicke der hochohmigen Schicht in der Größenordnung von 10-100nm liegt.

35. Halbleiterbauelement nach einem oder beiden der Ansprüche 33 und 34, **dadurch gekennzeichnet, dass** die Dicke der niedrigohmigen ZnO-Schicht in der Größenordnung von 0,1-2µm liegt.

36. Halbleiterbauelement nach einem oder mehreren der Ansprüche 21 bis 35, **dadurch gekennzeichnet, dass** das Halbleiterbauelement (11) mit einem Verfahren nach einem oder mehreren der Ansprüche 1 bis 20 hergestellt wurde.

37. Verfahren zur Herstellung einer Solarzelle mit integrierten kugel- oder kornförmigen Halbleiterbauelementen, **gekennzeichnet durch** folgende Merkmale:
- Einbringen von mehreren kugel- oder kornförmigen Halbleiterbauelementen (11) in eine isolierende Trägerschicht (70), wobei die Halbleiterbauelemente (11) wenigstens auf einer Seite der Trägerschicht aus der Oberfläche der Trägerschicht herausragen, und die Halbleiterbauelemente (11) jeweils aus einem kugel- oder kornförmigen Substratkern (20) bestehen, der wenigstens mit einer leitenden Rückkontaktschicht (30) und einer I-III-VI-Verbindungshalbleiterschicht (60) beschichtet ist;
- Abtragen von Teilen der Halbleiterbauelemente (11) auf einer Seite der Trägerschicht (10), so dass eine Fläche der leitenden Rückkontaktschicht (30) der Halbleiterbauelemente (11) freigelegt ist;
- Aufbringen einer Rückkontaktschicht (80) auf die Seite der Trägerschicht (10), auf welcher Teile der Halbleiterbauelemente (11) abgetragen sind; und
- Aufbringen einer Vorderkontaktschicht (90) auf die Seite der Trägerschicht (10), auf der keine Halbleiterbauelemente (11) abgetragen sind.

38. Verfahren nach Anspruch 37, **dadurch gekennzeichnet, dass** neben Teilen der Halbleiterbauelemente (11) ein Teil der Trägerschicht (10) abgetragen wird.

39. Verfahren nach einem oder beiden der Ansprüche 37 und 38, **dadurch gekennzeichnet, dass** neben der Vorderkontaktschicht (40) und der Rückkontaktschicht (50) weitere Funktionsschichten abgeschieden werden.

40. Verfahren nach einem oder mehreren der Ansprüche 37 bis 39, **dadurch gekennzeichnet, dass** die Halbleiterbauelemente (11) durch Streuen, Stäuben und/oder Drucken auf die Trägerschicht (70) aufgebracht und danach in die Trägerschicht eingebracht werden.

41. Verfahren nach einem oder mehreren der Ansprüche 37 bis 40, **dadurch gekennzeichnet, dass** die Trägerschicht (70) eine Matrix mit Aussparungen ist, in welche die Halbleiterbauelemente (11) eingebracht werden.

42. Verfahren nach einem oder mehreren der Ansprüche 37 bis 41, **dadurch gekennzeichnet, dass** die Halbleiterbauelemente (11) durch einen Erwärmungs- und/oder Pressvorgang in die Trägerschicht (70) eingebracht werden.

43. Verfahren nach einem oder mehreren der Ansprüche 37 bis 42, **dadurch gekennzeichnet, dass** das Abtragen der Halbleiterbauelemente (11) und/oder der Trägerschicht (70) durch Schleifen, Polieren, Ätzen, thermischen Energieeintrag und/oder photolithographische Prozesse erfolgt.

44. Verfahren nach einem oder mehreren der Ansprüche 37 bis 43, **dadurch gekennzeichnet, dass** die Rückkontaktschicht (80) und/oder die Vorderkontaktschicht (90) durch PVD- oder CVD-Verfahren oder andere an das Material der jeweiligen Schicht angepasste Verfahren abgeschieden werden.

45. Solarzelle mit integrierten kugel- oder kornförmigen Halbleiterbauelementen, **dadurch gekennzeichnet, dass** die Solarzelle wenigstens folgende Merkmale aufweist:
- eine isolierende Trägerschicht (70), in die kugel- oder kornförmige Halbleiterbauelemente (11) eingebracht sind, wobei die Halbleiterbauelemente (11) wenigstens auf einer Seite der Trägerschicht (70) aus der Schicht herausragen, und die Halbleiterbauelemente (11) jeweils aus einem kugel- oder kornförmigen Substratkern (20) bestehen, der wenigstens mit einer leitenden Rückkontaktschicht (30) und einem I-III-VI-Verbindungshalbleiter beschichtet ist,;
- eine Rückkontaktschicht (80) auf einer Seite der Trägerschicht (10), wobei mehrere Halbleiterbauelemente (11) auf dieser Seite der Trägerschicht eine Fläche aufweisen, die frei von I-III-VI-Verbindungshalbleiter ist; und
- eine Vorderkontaktschicht (90) auf der Seite der Trägerschicht (70), auf welcher die Halbleiterbauelemente (11) keine Fläche aufweisen, die frei von I-III-VI-Verbindungshalbleiter ist.

46. Solarzelle nach Anspruch 45, **dadurch gekennzeichnet, dass** sie mit einem Verfahren nach einem oder mehreren der Ansprüche 37 bis 44 hergestellt ist.

47. Solarzelle nach einem oder beiden der Ansprüche 45 und 46, **dadurch gekennzeichnet, dass** die isolierende Trägerschicht (70) aus einem thermoplastischen Material besteht.

48. Solarzelle nach einem oder mehreren der vorangegangenen Ansprüche 45 bis 47, **dadurch gekennzeichnet, dass** die Trägerschicht (10) aus einem Polymer aus der Gruppe der Epoxide, Polycarbonate, Polyester, Polyurethane, Polyacryle und/oder Polyimide besteht.

49. Solarzelle nach einem oder mehreren der vorangegangenen Ansprüche 45 bis 48, **dadurch gekennzeichnet, dass** es sich bei den kugel- oder kornförmigen Halbleiterbauelemente (11) um Halbleiterbauelemente nach einem oder mehreren der Ansprüche 21 bis 36 handelt.

50. Solarzelle nach einem oder mehreren der Ansprüche 45 bis 49, **dadurch gekennzeichnet, dass** die Halbleiterbauelemente (11) mit einem I-III-VI-Verbindungshalbleiter aus der Gruppe der Kupferindiumdiselenide, Kupferindiumdisulfide, Kupferindiumgalliumdiselenide und Kupferindiumgalliumdiseleniddisulfide beschichtet sind.

51. Solarzelle nach einem oder mehreren der Ansprüche 45 bis 50, **dadurch gekennzeichnet, dass** die Vorderkontaktschicht (90) aus einem leitenden Material besteht.

52. Solarzelle nach Anspruch 51, **dadurch gekennzeichnet, dass** die Vorderkontaktschicht (90) aus einem TCO (Transparent Conductive Oxide) besteht.

53. Solarzelle nach einem oder mehreren der Ansprüche 45bis 52, **dadurch gekennzeichnet, dass** die Rückkontaktschicht (80) aus einem leitenden Material besteht.

54. Solarzelle nach Anspruch 53, **dadurch gekennzeichnet, dass** die Rückkontaktschicht (80) aus einem Metall, einem TCO (Transparent Conductive Oxide) oder einem Polymer mit leitfähigen Partikeln besteht.

55. Solarzelle nach Anspruch 54, **dadurch gekennzeichnet, dass** die Rückkontaktschicht (80) aus einem Polymer aus der Gruppe der Epoxidharze, Polyurethane und/oder Polyimide mit leitfähigen Partikeln einer Gruppe aus Kohlenstoff, Indium, Nickel, Molybdän, Eisen, Nickelchrom, Silber, Aluminium und/oder entsprechenden Legierungen bzw. Oxiden besteht.

56. Solarzelle nach Anspruch 53, **dadurch gekennzeichnet, dass** die Rückkontaktschicht (80) aus einem intrinsischen leitfähigen Polymer besteht.

57. Solarzelle nach Anspruch 56, **dadurch gekennzeichnet, dass** die Rückkontaktschicht (80) aus einem Polymer aus der Gruppe der PANis besteht.

58. Solarzelle nach einem oder mehreren der Ansprüche 45 bis 57, **dadurch gekennzeichnet, dass** die Solarzelle neben der Vorderkontaktschicht (90) und der Rückkontaktschicht (80) weitere Funktionsschichten aufweist.

59. Photovoltaikmodul, **dadurch gekennzeichnet, dass** es wenigstens eine Solarzelle nach einem der mehreren der Ansprüche 45 bis 58 aufweist.
